# EUROPEAN PATENT APPLICATION

(11) **EP 2 562 765 A2**
(43) Date of publication of application: **27.02.2013**
(21) Application number: 12175854.4
(22) Date of filing: 11.07.2012
(51) Int. Cl.: G21K 1/02, H01J 37/09, H01J 37/18

(54) **Charged particle beam forming aperture and charged particle beam exposure apparatus**

(30) Priority: 23.08.2011 JP 2011181579
(71) Applicant: Canon Kabushiki Kaisha, Tokyo 146-8501 (JP)
(72) Inventor: Yoshitake, Tadayuki, Tokyo 146-8501 (JP); Ando, Yoichi, Tokyo 146-8501 (JP)
(74) Representative: TBK

(57) **Abstract**

An aperture (001, 003, 117) that forms a charged particle beam includes a non-evaporable getter (004) on a surface of the aperture (001, 003, 117). The non-evaporable getter (004) is disposed in a position to which the charged particle beam is irradiated. The degradation of the exhaust performance around a charged particle source (108) while the charged particle source (108) is driven is suppressed.

## Description

### BACKGROUND OF THE INVENTION

### Field of the Invention

The present invention relates to a charged particle beam forming aperture, which constitutes an electron optical system for controlling a charged particle beam, and a charged particle beam exposure apparatus using the charged particle beam forming aperture.

### Description of the Related Art

The electron beam exposure technique is a strong candidate of lithography that enables fine pattern exposure of 0.1 µm or less. A so-called multi-beam system is known, which renders a pattern on an object to be exposed by a plurality of electron beams at the same time without using a mask in order to improve throughput of electron beam exposure.

In the multi-beam system, an electron beam irradiated from a high-output electron source or a high-output electron source group is introduced into an electron optical system whose openings are arranged in a one-dimensional array or a two-dimensional array, so that a plurality of electron beams are obtained. An aperture on which openings are arranged into an array is used to form the beams.

In the electron beam exposure apparatus, the electron source and the electron optical system are disposed in a vacuum chamber and the inside of the chamber is maintained in a vacuumed state. In particular, the life of the electron source (a charged particle source) is shortened due to evaporation of an emission portion by heat and ion bombardment of ionized ambient gas, so that a high degree of vacuum is required around the electron source.

A technique is known in which an exhaust apparatus is installed near the electron source separately from an exhaust apparatus for the entire chamber in order to improve the degree of vacuum around the electron source. For example, a technique is known in which a getter pump is disposed on an inner wall of an apparatus as an exhaust apparatus to exhaust gas. The getters are roughly divided into two types: "evaporable getter" and "non-evaporable getter: hereinafter referred to NEG".

The evaporable getter uses a metal film deposited on an inner wall of a container in vacuum as a pump (an evaporable getter pump) without change. A typical material of the evaporable getter is barium (Ba).

On the other hand, the NEG includes a metal such as titanium (Ti), zirconium (Zr), and vanadium (V) or an alloy including the above metals as main components. The NEG is formed on an inner wall of a container by deposition, sputtering, or the like. When the NEG is heated in vacuum or in an atmosphere of inert gas, a gas (for example, hydrogen, oxygen, and nitrogen) absorbed on the surface of the NEG is diffused inside the NEG and a clean metal surface is exposed on the upper most surface. Thereby, a residual gas in the vacuum is absorbed on the NEG (NEG pump). This heating process is called "activation". Both types of getters are an accumulation type pump and have characteristics that the more the getter absorbs gas, the lower the exhaust performance is.

Japanese Patent Laid-Open No. 2004-214480 discloses an exposure apparatus using an evaporable getter as a getter pump. The evaporable getter evaporates the material to be a getter again when the exhaust performance degrades and forms a new metal film on a metal film whose exhaust performance degrades, so that the evaporable getter can restore the exhaust performance. However, the evaporable getter has a problem that, when the getter metal is evaporated, particles of the getter metal scatter in the chamber and exist (float) in the space for a certain period of time, so that the particles may hit an electron beam and the ionized particles attack an electron source (ion bombardment), or may contaminate the object to be exposed.

Japanese Patent Laid-Open No. 2010-10125 discloses a charged particle beam apparatus using an NEG as a getter pump. When the exhaust performance of the NEG pump degrades, the exhaust performance can be restored by heating the getter and activating the getter. However, a sintered compact is generally used for a conventional NEG, so that dust emission may occur depending on the heating method (activation method). For example, if heating is performed by a charged particle beam such as electron beam irradiation, dust emission may occur, so that there is a problem that it is difficult to activate a non-active type getter formed of a sintered compact by electron beam irradiation without dust emission.

Aspects of the present invention prevent degradation of the exhaust performance while driving a charged particle source by a simple configuration without contaminating areas around the charged particle source in a configuration in which a gas around the charged particle source is exhausted by using a getter pump.

### SUMMARY OF THE INVENTION

Aspects of the present invention are directed to an aperture for forming a charged particle beam. The aperture includes an NEG on a surface of the aperture and the NEG is disposed at a position to which the charged particle beam of the aperture is irradiated.

The present invention in its first aspect provides an aperture as specified in claims 1 to 7.

The present invention in its second aspect provides a charged particle beam exposure apparatus as specified in claim 8.

According to aspects of the present invention, a getter (a getter pump) formed by NEG receives irradiation of a charged particle beam and maintains an activated state by an energy of the charged particle beam. Therefore, it is possible to prevent the exhaust capacity from degrading. Further, it is possible to maintain an activated state with exhaust performance higher than that in a room temperature, so that the degree of vacuum around the charged particle source can be maintained at a high level for a long period of time. The getter is disposed at a position to which the electron beam is irradiated, so that the conductance between the getter and the charged particle source which requires a high degree of vacuum is small and a satisfactory vacuum around the charged particle source is maintained.

Further features of the present invention will become apparent from the following description of exemplary embodiments with reference to the attached drawings.

### BRIEF DESCRIPTION OF THE DRAWINGS

Figs. 1A and 1B are schematic views of an aperture.

Figs. 2A to 2C show a getter forming process.

Fig. 3 is a schematic view 1 of an electron beam exposure apparatus.

Fig. 4 is a schematic view 2 of the electron beam exposure apparatus: vacuum forming unit.

Fig. 5 shows a relationship between crystalline and H₂O exhaust characteristics.

### DESCRIPTION OF THE EMBODIMENTS

Hereinafter, embodiments of the present invention will be described. However, the present invention is not limited to the description below.

In the present invention, a charged particle optical system means an entire configuration in which a charged particle beam generated by a charged particle source is irradiated to an object to be exposed. An auxiliary vacuum pump means a getter pump, which is a vacuum pump for exhausting a gas around a charged particle beam generator.

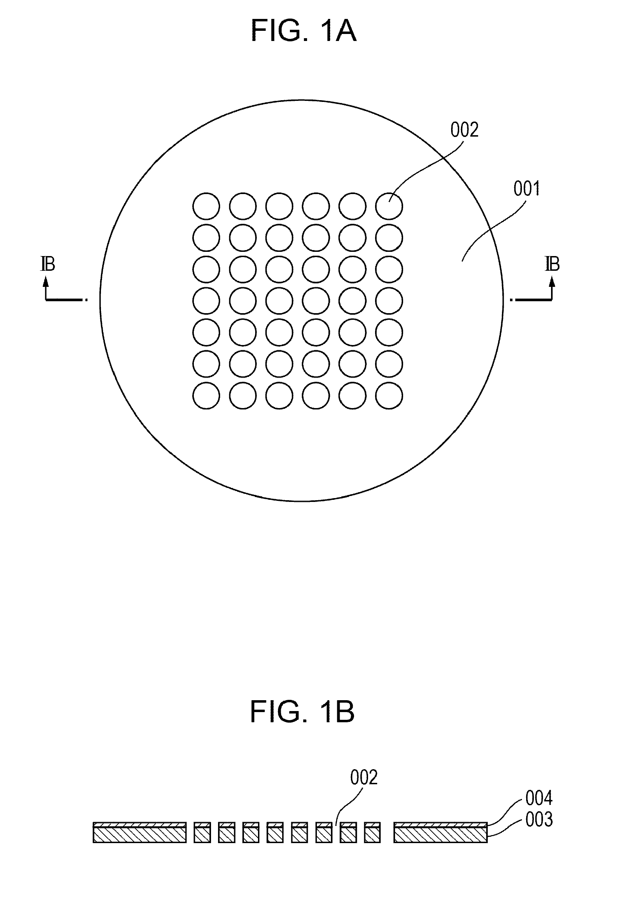

An aperture of a first embodiment of the present invention will be described with reference to Figs. 1 to 3.

Fig. 1A is a top view of the aperture according to aspects of the present invention. A part of a charged particle beam is blocked by the aperture 001 and a part of the charged particle beam passes through through-holes 002 provided in the aperture 001 and is irradiated to an object to be exposed. Such an aperture or a combination of a plurality of the apertures is disposed on a path of the charged particle beam, so that the charged particle beam passing through the through-holes in the apertures is divided into a predetermined number of beams and/or formed into a predetermined shape.

Fig. 1B is a cross-sectional view taken along line IB-IB in Fig. 1A. A getter 004 is disposed on a surface of an aperture 003 to which the charged particle beam is irradiated. Both the aperture 003 and the getter 004 include through-holes 002 through which the charged particle beam passes.

In Fig. 1A, the aperture includes a plurality of through-holes which are arranged in a two-dimensional shape and which have a circular cross section. However, the through-holes may be arranged in a one-dimensional shape. The aperture may include one through-hole instead of a plurality of through-holes. The cross-sectional shape of the through-hole may be a polygonal shape or any other shape instead of the circular shape as shown in Fig. 1A.

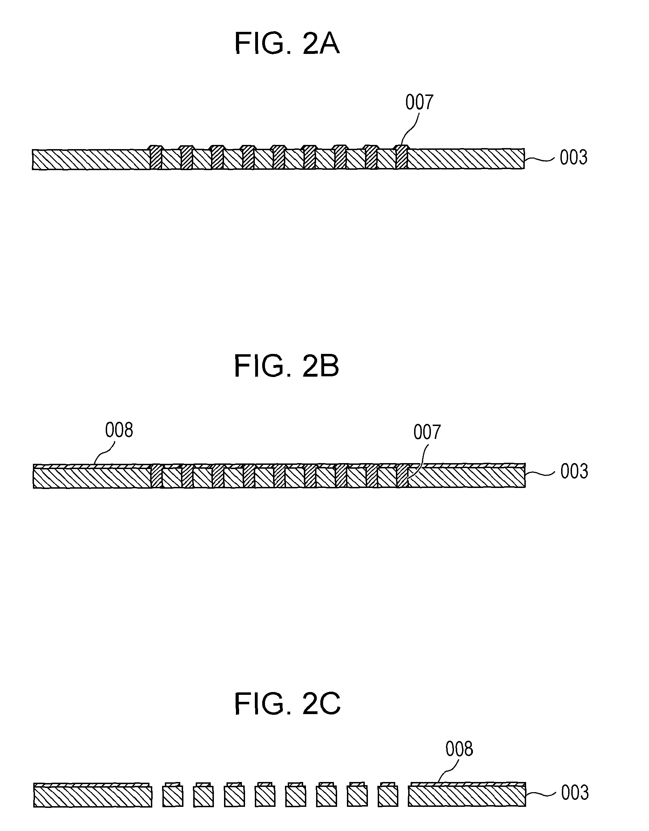

Figs. 2A to 2C are cross-sectional views of the aperture, which show a process for providing a getter that functions as an auxiliary vacuum pump to the aperture according to aspects of the present invention.

Fig. 1B shows a state in which the getter 004 is disposed on the entire area of the surface of the aperture 003, to which the charged particle beam is irradiated, other than areas in which through-holes 002 are formed. However, it is not necessary for the getter 004 to be disposed on the entire area of the surface of the aperture 003, to which the charged particle beam is irradiated and in which the through-holes 002 are not formed. For example, when the degree of accuracy of the inside diameter of the through-hole 002 formed in the aperture 003 is to be higher, an area (position) on which the getter 004 is disposed may need to be adjusted. When the charged particle beam enters the surface of the aperture, to which the charged particle beam is irradiated, at a predetermined angle to the surface, if a predetermined width of an opening width (an opening diameter) of the aperture on the incident path is to be secured, an area (position) on which the getter 004 is disposed may need to be adjusted. Specifically, as shown in Fig. 2C, the getter 004 is disposed on an area of the surface of the aperture 003 to which the charged particle beam is irradiated except for areas in which the through-holes 002 are formed and areas having a predetermined size around the through-holes 002. The inside diameter of the through-holes formed in the getter may be larger than the inside diameter of the through-holes of the aperture so that the getter does not exist on the trajectory of the charged particle beam. At this time, a satisfactory difference between the inside diameter of the through-holes of the getter and the inside diameter of the through-holes of the aperture is a length which is the same as the thickness of the getter or several times the thickness of the getter. In such a configuration, the larger the size of the through-holes of the getter is, the smaller the area of the getter is. However, the reduced area is sufficiently small with respect to the area of the entire getter, so that the exhaust capacity of the getter pump, which is an auxiliary vacuum pump, does not decrease largely. It is possible to increase the degree of vacuum around the charged particle beam generator by the aperture including the getter according to aspects of the present invention.

As another configuration, the NEG may be formed (disposed) on the inner wall of the through-holes in the aperture. The exhaust capacity of the getter pump can be relatively increased by such a configuration.

A metal film and a metal laminated film formed of a predetermined metal material having a large specific surface area can be used for the NEG of the present invention. However, an NEG formed of a sintered compact, which is widely used as an NEG, is not suitable for the NEG of the present invention because the NEG formed of a sintered compact has a risk that dust emission is caused by the charged particle irradiation.

In the present invention, at least one layer of the getter (getter layer) may be formed on the aperture. However, two or more layers of the getter may be formed. When the exhaust capacity of the getter of the first layer cannot be restored even if activated by heat treatment or the like, a new getter of the second layer can be formed on the first layer.

Any film forming method such as a plasma spraying method, an electron beam evaporation method, a sputtering method, and a resistance heating vapor deposition method can be used as a film forming method of the getter.

Hereinafter, specific examples of materials and dimensions of the present embodiment will be described.

The aperture 003 of the present embodiment is formed of single crystal Si. As a material used for the aperture 003, a metal such as Si, Cu, W, and Mo can be used to improve thermal conductivity. As a material used for the getter 004, a metal such as Ti, Zr, and V or an alloy of these metals can be used. In the present embodiment, Ti is used as a material of NEG.

Hereinafter, a specific manufacturing method of the present embodiment will be described with reference to Figs. 2A to 2C. In the aperture 003, through-holes are formed in a single crystal silicon substrate by using photolithography and deep dry etching. The thickness of the silicon substrate is 525 µm. The inside diameter of the through-holes is 18 µm. Next, the getter 004 is formed on the aperture 003 by the procedure described below using lift-off patterning. First, a positive resist is coated on the silicon substrate in which the through-holes are formed. When areas near the through-holes are masked and the silicon substrate is exposed and developed, as shown in Fig. 2A, holes are filled with resist 007. At this time, the resist is left not only in the through-holes, but also around the through-holes, so that through-holes having an inside diameter larger than that of the through-holes can be formed in the getter (getter layer). Subsequently, as shown in Fig. 2B, a Ti film is formed as the getter layer on the aperture on which the resist is patterned. The sputtering method is used as the film forming method. The film thickness is 900 nm. The film thickness of 500 nm to 1500 nm is preferable for the film to sufficiently function as a getter layer. Finally, when the resist layer is peeled off, as shown in Fig. 2C, the getter layer 008 is lift-off patterned. By the process describe above, the aperture according to aspects of the present invention, which has a getter at a position to which a charged particle beam is irradiated, can be manufactured. Although Figs. 2A to 2C show a configuration in which one resist layer is formed, a plurality of resist layers may also be laminated and patterned. When a plurality of resist layers are formed, areas on which the resist is formed are changed for each resist layer, so that a cross section of the laminated resist layers can have a taper shape or a step-like shape. For example, when the cross section of the resist is formed into a reverse taper shape, it is possible to prevent burrs and the like from occurring when the getter layer is lifted off.

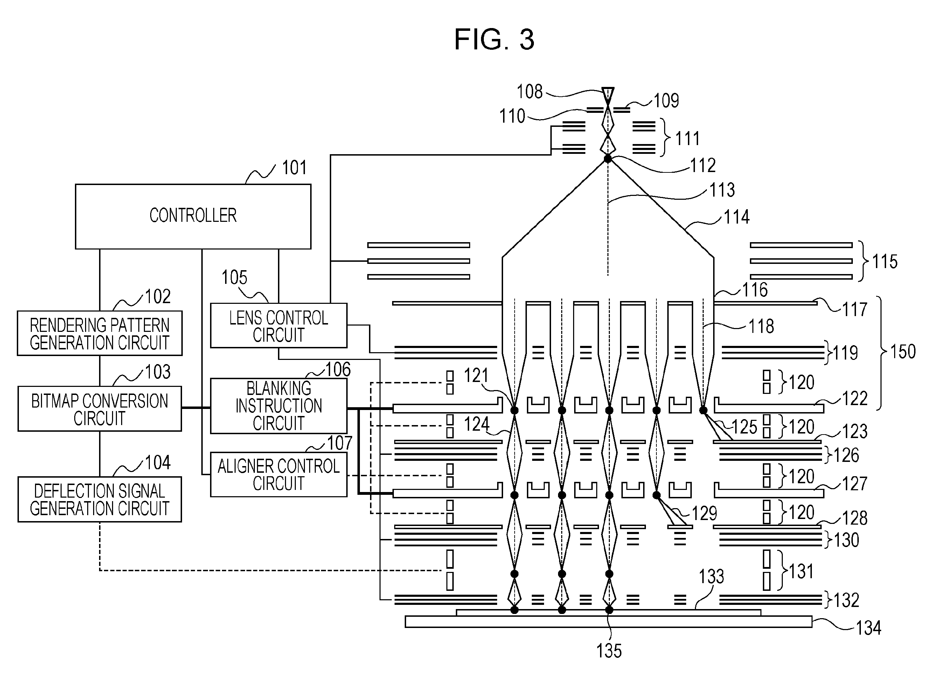

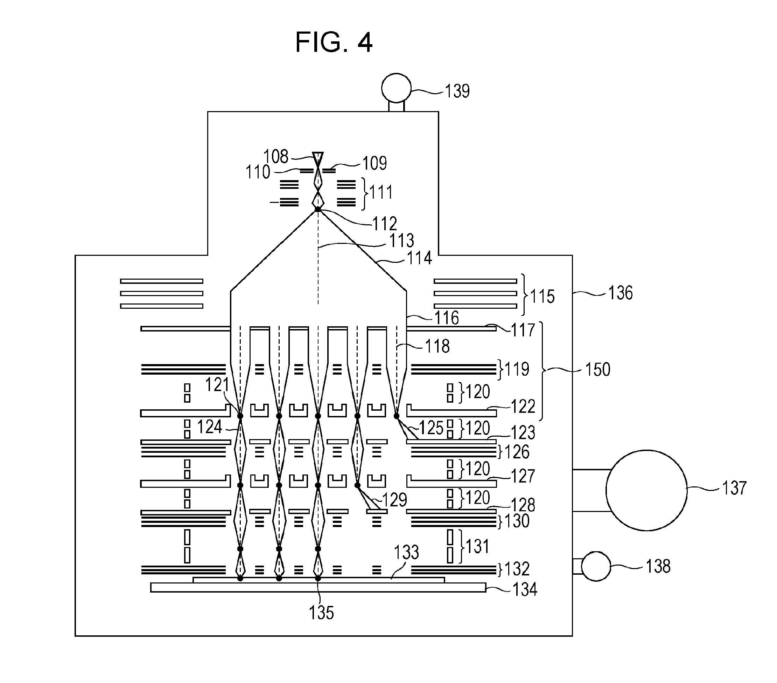

A charged particle beam exposure apparatus, which is a second embodiment of the present invention, will be described with reference to Figs. 3 and 4.

Fig. 3 is a diagram showing a configuration of a multiple charged particle beam exposure apparatus using an aperture having the same configuration as that of the first embodiment of the present invention. The present embodiment is a multi-column system which includes separate projection systems.

A radiation charged particle beam drawn from a charged particle source 108 by an anode electrode 110 forms an irradiation optical system crossover 112 by a crossover adjustment optical system 111.

Here, as the charged particle source 108, a so-called thermionic type electron source such as LaB6 and BaO/W (dispenser cathode) is used.

The crossover adjustment optical system 111 includes first and second electrostatic lenses. Both the first and the second electrostatic lenses are a so-called einzel type electrostatic lens which includes three electrodes and in which a negative voltage is applied to the intermediate electrode and the upper and the lower electrodes are grounded.

A charged particle beam radiated to a wide area from the irradiation optical system crossover 112 is converted into a collimated beam (a charged particle beam) by a collimator lens 115 and irradiated to an aperture 117.

As the aperture 117, the aperture manufactured by the manufacturing method described in the first embodiment is used. As described above, the charged particle beam is irradiated to the aperture 117, so that the getter is activated and the exhaust capacity of the getter pump is maintained in a good condition, so that it is possible to maintain a high degree of vacuum around the charged particle source 108. At this time, dust is not emitted from the getter to which the charged particle beam is irradiated, so that the areas around the getter are not contaminated and cleanness of the atmosphere is maintained.

Multiple charged particle beams 118 divided by the aperture 117 are individually focused by a focusing lens array 119 and form images on a blanker array 122.

Here, the focusing lens array 119 is an electrostatic lens array including three porous electrodes. The electrostatic lens is a so-called einzel type electrostatic lens array in which a negative voltage is applied to only the intermediate electrode of the three electrodes and the upper and the lower electrodes are grounded.

The aperture 117 is placed at a pupil plane position of the focusing lens array 119 (at a focal plane position in front of the focusing lens array) to cause the aperture 117 to have a role to determine NA (convergence half angle).

The blanker array 122 is a device having individual deflecting electrodes. The blanker array 122 turns on and off a charged particle beam individually according to a rendering pattern on the basis of a blanking signal generated by a rendering pattern generation circuit 102, a bitmap conversion circuit 103, and a blanking instruction circuit 106.

When the charged particle beam is in a state of on, no voltage is applied to the deflecting electrode of the blanker array 122 and when the charged particle beam is in a state of off, a voltage is applied to the deflecting electrode of the blanker array 122, so that the multiple charged particle beams are deflected. The multiple charged particle beam 125 deflected by the blanker array 122 are blocked by the stop aperture 123 in the next stage and the charged particle beam becomes in a state of off.

In the present embodiment, the blanker array is formed by two stages. A second blanker array 127 and a second stop aperture 128, which have the same structures as those of the blanker array 122 and the stop aperture 123, are disposed in the next stage.

Multiple charged particle beams passing through the blanker array 122 form images on the second blanker array 127 by a second focusing lens array 126. Further the multiple charged particle beams are focused by a third focusing lens array 130 and a fourth focusing lens array 132 and form images on a wafer 133. Here, the second focusing lens array 126, the third focusing lens array 130, and the fourth focusing lens array 132 are an einzel type electrostatic lens array in the same manner as the focusing lens array 119.

The fourth focusing lens array 132 includes objective lenses whose reduction ratio is set to about 1/100. Thereby, the charged particle beam 121 (whose spot diameter is 2 µm in FWHM) on an intermediate image plane of the blanker array 122 is reduced to 1/100 on a surface of the wafer 133, so that the multiple charged particle beam having an FWHM of about 20 nm forms an image on the wafer which is a sample (an object to be exposed). Here, the FWHM means a full width at half maximum.

The multiple charged particle beams on the wafer can be scanned by a deflector 131. The deflector 131 is formed by counter electrodes. The deflector 131 includes four-stage counter electrodes to perform two-stage deflection in x and y directions (a two-stage deflector is shown as one unit for simplicity in Fig. 3). The deflector 131 is driven according to a signal of a deflection signal generation circuit 104.

While a pattern is being rendered, the wafer 133 is continuously moved in the X direction by a stage 134. The charged particle beam 135 on the surface of the wafer is deflected in the Y direction by the deflector 131 on the basis of a length measurement result in real time by a laser length measuring machine. The blanker array 122 and the second blanker array 127 turn on and off the charged particle beams individually according to the rendering pattern. Thereby it is possible to quickly render a desired pattern on the surface of the wafer 133.

As shown in Fig. 4, the electron optical system except for a control circuit in the above configuration is disposed inside the chamber 136 and gas inside the chamber 136 is exhausted by a turbo-molecular pump 137. The pressure inside the chamber is measured by a pressure gauge A 138 and a pressure gauge B 139.

The pressure inside the chamber measured by the pressure gauge A and the pressure gauge B is the same 1×10⁻³ [Pa] when a normal aperture, on the surface of which no getter is disposed, is used as the aperture 117. When the aperture manufactured by the manufacturing method described in the first embodiment is used as the aperture 117, the pressure inside the chamber measured by the pressure gauge A is 1×10⁻³ [Pa] and the pressure measured by the pressure gauge B is 5×10⁻⁵ [Pa].

The life of the charged particle source in the present embodiment is evaluated and it is confirmed that the degradation of the charged particle source is suppressed when the aperture according to aspects of the present invention is used.

In the present embodiment, the case, in which the aperture manufactured by the method described in the first embodiment is used as the aperture 117, is described as an example. However, even if the getter is disposed on other members to which the charged particle beam is irradiated, the same effect can be expected. For example, the getter may be disposed on portions of the stop apertures 123 and 128, to which the charged particle beam is irradiated.

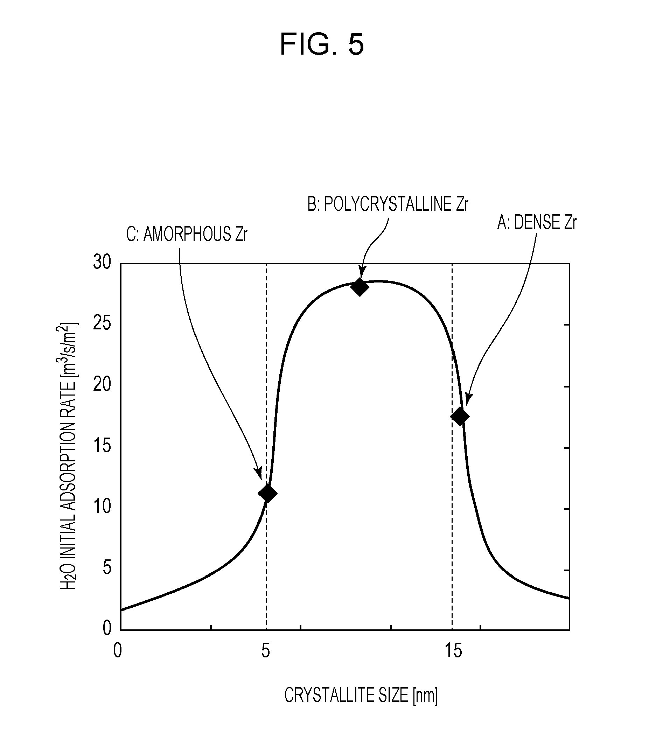

A configuration in which a getter including a polycrystalline metal deposited film is disposed on an upper most surface of an aperture according to a third embodiment of the present invention will be described with reference to Fig. 5.

Prior to the description of the present embodiment, a relationship between the exhaust capacity of an NEG and a crystalline structure of the NEG will be described.

An activated NEG has an active metal layer on the upper most surface of the NEG, combines with incoming gas molecules, and absorbs the gas molecules, so that the NEG exhausts the gas. Regarding the exhaust capacity of the NEG, the larger the surface area which absorbs the gas molecules, the larger the amount of gas being absorbed, so that the larger the specific surface area of the NEG, the larger the exhaust capacity of a getter formed per unit area of the aperture.

A highly crystalline metal layer having a large crystallite size, that is, a dense metal layer, has a large filling rate (density) and a small specific surface area because of the density. A so-called amorphous metal layer, which has a low crystalline structure and an extremely small crystallite size, also has a large filling rate (density) as a layer because the amorphous metal does not form a structure, so that the amorphous metal layer also has a small specific surface area.

On the other hand, a metal layer having a middle crystalline structure and a middle crystallite size between those of the above metal layers has an appropriate polycrystalline structure. A metal layer having a polycrystalline structure forms a layer structure which has a low filling rate and many holes because of layers of fine crystal structures (the metal layer has an appropriate void ratio). Therefore, the metal layer has a large specific surface area and shows large exhaust capacity when used as an NEG.

NEGs having different crystalline structures are manufactured and a relationship between the crystalline structure and the exhaust capacity is measured. A getter A having a high crystalline structure, a getter B which is a polycrystalline film, and a getter C which has a low crystalline structure and has an amorphous structure, which are used for the measurement, are formed by the procedure described below.

First, a Ti film getter, which has a flat glass shape and large unevenness, is formed by sputtering. Subsequently, a film forming condition is changed and a Zr film, which has a different crystalline structure, is formed by sputtering. The reason why the Ti film getter is used as a lower layer of the Zr film is to increase the exhaust capacity by forming unevenness and facilitate the measurement.

Fig. 5 shows a measured relationship between the crystalline structures and an H₂O exhaust rate immediately after activation. As a scale of the crystalline structure, the crystallite size is used. The crystallite size is converted from a half width of a peak of XRD (X-Ray Diffraction) by using the formula of Scherrer "D = Kλ/βcosθ". The crystal face used in the measurement is [100] face, D is an average value of the crystallite sizes, K is the Scherrer constant, λ is the wavelength of the X-ray, β is the half width of the peak in the XRD measurement, and θ is the diffraction angle of the peak in the XRD measurement. Here, X'Pert PRO MRD by PANalytical is used in the XRD measurement. In the present specification, the wavelength of the X-ray used in the measurement is 1.5 angstrom. The Scherrer constant K is 0.9 and the peak diffraction angle θ is 35 degrees.

The reason why the H₂O gas is used as an exhaust rate index is because the H₂O gas is very difficult to exhaust in the apparatus and high exhaust capacity is required for the H₂O gas.

Fig. 5 shows that the exhaust rate is small in the area where the crystallite size is small and the area where the crystallite size is large, so that it is known that there is an appropriate crystallite size as an NEG. In practice, it can be defined that the full width half maximum of the graph of Fig. 5 is an area that effectively functions as an NEG, so that, from Fig. 5, the effective numerical range can be estimated to be greater than or equal to 5 nm and smaller than or equal to 15 nm. Here, when considering coefficients and the like that depend on the measurement apparatus, the Scherrer constant K may have a range of about 0.9 ± 0.3. Therefore, according to aspects of the present invention, considering the error due to the apparatus, it can be defined that the crystallite size effectively functioning as an NEG is greater than or equal to 3 nm and smaller than or equal to 20 nm. In a metal polycrystal, the crystallite size may be seen different depending on the direction. Therefore, if an average crystallite size is within the above crystallite size range, the entire structure of the layer is not affected, so that the features of the NEG are not damaged.

Although, in the present embodiment, the crystallite size is specified by using the [001] face, even if the crystallite size is related to an arbitrary axis direction or the crystallite size is related to a specific axis direction, the features of the NEG are not damaged.

In a fourth embodiment, a case will be described in which a laminated film of Ti and the polycrystalline Zr that is the same as the sample B whose filming method is described in the third embodiment is used as an NEG of the aperture 117 in the charged particle beam exposure apparatus described in the second embodiment.

At this time, the pressure inside the chamber measured by the pressure gauge A is 1×10⁻³ [Pa] and the pressure measured by the pressure gauge B is 1×10⁻⁵ [Pa]. From the above result, it is confirmed that the degree of vacuum around the charged particle source is improved when a polycrystalline film is disposed on the upper most surface of the NEG. The life of the charged particle source is measured and it is confirmed that the degradation is suppressed more than the case in the second embodiment. While the present invention has been described with reference to exemplary embodiments, it is to be understood that the invention is not limited to the disclosed exemplary embodiments. The scope of the following claims is to be accorded the broadest interpretation so as to encompass all such modifications and equivalent structures and functions.
An aperture (001, 003, 117) that forms a charged particle beam includes a non-evaporable getter (004) on a surface of the aperture (001, 003, 117). The non-evaporable getter (004) is disposed in a position to which the charged particle beam is irradiated. The degradation of the exhaust performance around a charged particle source (108) while the charged particle source (108) is driven is suppressed

## Claims

1. An aperture which forms a charged particle beam, the aperture comprising:
a non-evaporable getter (004),
wherein the non-evaporable getter (004) is disposed in a position of the aperture (001, 003, 117), to which the charged particle beam is irradiated.

2. The aperture according to Claim 1, wherein
the non-evaporable getter includes at least one layer of metal deposited film,
the metal deposited film has a polycrystalline structure, and
a crystallite size of the polycrystalline structure is greater than or equal to 3 nm and smaller than or equal to 20 nm.

3. The aperture according to Claim 1, further comprising:
a plurality of through-holes.

4. The aperture according to Claim 3, wherein
each of the plurality of through-holes has a circular cross-sectional shape, and
the through-holes are two-dimensionally arranged.

5. The aperture according to Claim 3, wherein
the non-evaporable getter is disposed on an entire area of a surface of the aperture, to which the charged particle beam is irradiated and where the through-holes are not formed.

6. The aperture according to Claim 3, wherein
the non-evaporable getter is disposed on an entire area of a surface of the aperture, to which the charged particle beam is irradiated, other than areas where the through-holes are formed and areas having a predetermined size around the through-holes.

7. The aperture according to Claim 1, wherein
the non-evaporable getter is formed of a titanium layer, a zirconium layer, or a laminated layer of the titanium layer and the zirconium layer, with a film thickness of 500 nm to 1500 nm, and
the non-evaporable getter is formed on a silicon substrate.

8. A charged particle beam exposure apparatus comprising:
a charged particle beam generation means;
an aperture (001, 003, 117) configured to form the charged particle beam;
a charged particle optical system configured to irradiate the charged particle beam to an object to be exposed;
an exhaust means arranged to exhaust gas in the charged particle optical system; and
an auxiliary vacuum pump configured to exhaust gas around the charged particle beam generation means,
wherein the auxiliary vacuum pump includes a non-evaporable getter (004), and
the non-evaporable getter (004) is disposed on a surface of the aperture (001, 003, 117) in a position to which the charged particle beam is irradiated.
